# DEMANDE DE BREVET EUROPEEN

(11) **EP 3 136 541 A1**
(43) Date de publication de la demande: **01.03.2017**
(21) Numéro de dépôt: 16180578.3
(22) Date de dépôt: 21.07.2016
(51) Int. Cl.: H02J 7/16, H02J 7/24

(54) **CIRCUIT D'EXCITATION D'UN ALTERNATEUR DE VÉHICULE AUTOMOBILE, RÉGULATEUR DE TENSION ET ALTERNATEUR L'INCORPORANT**

(30) Priorité: 28.08.2015 FR 1557988
(71) Demandeur: VALEO EQUIPEMENTS ELECTRIQUES MOTEUR, 94046 Créteil Cedex (FR)
(72) Inventeur: DE LAMARRE, Laurent, 75020 PARIS (FR); TISSERAND, Pierre, 94450 LIMEIL BREVANNES (FR); SARDAT, Pierre, 93340 LE RAINCY (FR); LABISTE, Laurent, 94100 Saint Maur des Fossés (FR); CHASSARD, Pierre, 94000 CRETEIL (FR); DUTHILLEUL, Guillaume, 33 770 SALLES (FR); RAGAINE, Pierre-François, 77120 SAINTS (FR); MORVANY, Romuald, 78180 MONTIGNY LE BRETONNEUX (FR); LAGRANGE, Jérémy, 94450 LIMEIL BREVANNES (FR)
(74) Mandataire: Duprez, Richard

(57) **Abrégé**

Le circuit d'excitation selon l'invention contrôle un courant d'excitation (lexc) dans un enroulement d'excitation (2) d'un alternateur au moyen d'une boucle de régulation d'une tension réseau de bord (Vbat+, 3) du véhicule, et comporte un premier transistor de puissance MOS (9) connecté entre une première borne d'alimentation positive Vbat+ (6) et une première borne d'excitation (7) et commandé par la boucle de régulation au moyen d'un premier circuit de pilotage (10), et un second transistor de puissance MOS (11) connecté entre la première borne d'excitation et une seconde borne d'excitation (8) reliée à une borne de masse (5) et faisant fonction de diode de roue libre en étant commandé au moyen d'un second circuit de pilotage (12). Conformément à l'invention, le circuit comprend en outre une boucle d'asservissement (15) d'une tension drain- source (Vds) du second transistor.

## Description

### DOMAINE TECHNIQUE DE L'INVENTION.

La présente invention concerne un circuit d'excitation d'un alternateur de véhicule automobile, ainsi que le régulateur de tension et l'alternateur comprenant ce circuit d'excitation.

### ARRIERE PLAN TECHNOLOGIQUE DE L'INVENTION.

Dans un alternateur d'automobile, une tension du réseau de bord est régulée en contrôlant une intensité du flux magnétique, issu d'un enroulement d'excitation d'un rotor, traversant les enroulements d'un stator. Cette fonction est assurée par un circuit d'excitation qui ajuste une valeur d'un courant d'excitation du rotor en fonction des variations de charges et de vitesse de rotation de l'alternateur.

Un exemple de ce type de circuit d'excitation est donné dans la demande de brevet français FR2733097 de la société VALEO EQUIPEMENTS ELECTRIQUES MOTEUR.

Afin de limiter efficacement des pertes par dissipation, un étage électronique de puissance de ce circuit est commandé en commutation à une fréquence fixe ou variable. Une tension aux bornes de l'enroulement d'excitation est portée au potentiel de la batterie pendant un temps donné, puis relâchée jusqu'à la fin de la période d'excitation. En régime établi une valeur moyenne d'un courant d'excitation est proportionnelle au rapport d'un temps à l'état haut sur une période d'un signal d'excitation. Ce rapport cyclique est déterminé par une boucle de régulation d'un régulateur.

Lorsque l'excitation est relâchée, le courant dans l'enroulement du rotor ne peut pas s'interrompre instantanément.

L'étage électronique de puissance doit fournir un chemin de conduction pour permettre au courant du rotor de circuler librement. Cette fonction est traditionnellement réalisée par une diode dite de « roue libre » placée en parallèle sur l'enroulement d'excitation et qui s'active naturellement lorsque la tension aux bornes du rotor devient négative.

Pour éviter des effets dus à l'environnement, tels qu'une corrosion ou une apparition de ponts salins, l'enroulement du rotor est généralement connecté au potentiel neutre de l'alternateur. L'étage d'excitation d'un régulateur est ainsi composé:
- d'un transistor de puissance connecté entre une borne positive de l'alternateur et une borne positive de l'enroulement d'excitation;
- d'une diode, connectée aux bornes de l'enroulement d'excitation;
- d'un circuit de contrôle d'excitation.

Dans le cas d'une intégration dans un circuit intégré, actuellement en majorité utilisant une technologie BCD, un premier élément de commutation « high side » est un premier transistor de puissance généralement de type NMOS. La diode de roue libre est réalisée en exploitant la diode base- émetteur d'un transistor bipolaire. L'inconvénient de la diode est de générer des pertes Vf*If*Do.

Certaines technologies utilisent la diode intrinsèque d'un NMOS, le transistor étant maintenu en régime bloqué. Les diodes intrinsèques ont généralement de moins bonnes performances que les diodes bipolaires.

Un premier circuit de pilotage d'une première tension de grille du premier transistor « high side » fait l'interface avec la logique de la boucle de régulation. Ce premier circuit de pilotage doit gérer les pentes de commutation de manière à :
- contrôler la forme de la commutation de courant pour limiter les émissions CEM sur le réseau de bord;
- optimiser le temps de commutation afin de limiter les pertes en commutation.

Des exemples de stratégies de commandes de grille réalisant cette gestion sont connus de l'état de la technique.

Un second élément de commutation « low side » étant disponible en technologie BCDMOS, il est également connu de l'homme de métier de le piloter en opposition du premier transistor d'excitation « high side », de manière à le rendre passant lors des phases de roue libre. L'avantage de cette solution est d'avoir des pertes en conduction faibles, liées à la diminution de la résistance équivalente (RDSon) entre une source et un drain du second transistor « low side ».

Cependant, pour éviter une conduction simultanée des deux transistors, un circuit de commande doit envoyer des signaux de commande de la première tension de grille et d'une seconde tension de grille du second transistor non recouvrants. Le circuit de commande doit donc gérer des temps morts entre des activations des transistors.

Un tel circuit de commande présente aussi le désavantage d'avoir un mode commun entre les commandes des transistors de puissance « high side » et « low side », en particulier lors d'épreuves CEM, ce qui peut rendre difficile son utilisation dans le monde de l'automobile.

### DESCRIPTION GENERALE DE L'INVENTION.

La présente invention vise par conséquent à pallier ces inconvénients.

Elle a précisément pour objet un circuit d'excitation d'un alternateur de véhicule automobile du type de ceux aptes à contrôler un courant d'excitation dans un enroulement d'excitation de cet alternateur en fonction d'une commande d'une boucle de régulation d'une tension d'un réseau de bord du véhicule alimenté par une batterie à laquelle est raccordé cet alternateur.

Le circuit d'excitation dont il s'agit comporte au moins:
- une première borne de masse destinée à être reliée à une masse du réseau de bord;
- une première borne d'alimentation destinée à être reliée à une ligne positive du réseau de bord;
- des première et seconde bornes d'excitation destinées à être reliées à l'enroulement d'excitation;
et il comprend:
- un premier transistor de puissance de type MOS connecté entre la première borne d'alimentation et la première borne d'excitation, apte à être commandé par la boucle de régulation au moyen d'un premier circuit de pilotage d'une première tension de grille ;
- un second transistor de puissance de type MOS connecté entre les première et seconde bornes d'excitation et à la première borne de masse faisant fonction d'une diode de roue libre en étant commandé au moyen d'un second circuit de pilotage d'une seconde tension de grille.

Selon l'invention, ce circuit d'excitation d'un alternateur de véhicule automobile comprend en outre une boucle d'asservissement d'une tension drain-source du second transistor de puissance.

Selon l'invention encore, cette boucle d'asservissement comprend:
- un dispositif de retour conditionnant la tension drain- source;
- un dispositif de génération d'une tension de référence;
- un dispositif de calcul d'erreur;
- un dispositif de correction d'erreur;
- le second circuit de pilotage.

Le dispositif de correction est selon l'invention de type "proportionnel intégral".

Dans le circuit d'excitation d'un alternateur de véhicule automobile selon l'invention le second circuit de pilotage est un amplificateur opérationnel comportant une boucle de contre-réaction constituée par une première résistance et un condensateur en série.

Selon l'invention, le dispositif de génération d'une tension de référence est constitué par un générateur de courant connecté à une entrée inverseuse de l'amplificateur opérationnel.

Selon l'invention encore, le dispositif de retour est constitué par cet amplificateur opérationnel, l'entrée inverseuse étant reliée par une deuxième résistance à la première borne d'excitation, et une entrée non-inverseuse de cet amplificateur opérationnel étant reliée à la seconde borne d'excitation.

Une sortie de l'amplificateur opérationnel pilote par l'intermédiaire d'une troisième résistance 27 la seconde tension de grille, selon l'invention.

Alternativement, dans le circuit d'excitation d'un alternateur de véhicule automobile selon l'invention, le dispositif de génération d'une tension de référence est connecté entre une entrée non-inverseuse de l'amplificateur opérationnel et la seconde borne d'excitation.

L'invention concerne aussi un régulateur de tension de véhicule qui comprend un circuit d'excitation présentant les caractéristiques ci-dessus.

Un alternateur de véhicule automobile comprenant un tel régulateur est aussi visé par l'invention.

Ces quelques spécifications essentielles auront rendu évidents pour l'homme de métier les avantages apportés par le circuit d'excitation selon l'invention, ainsi que le régulateur de tension et l'alternateur l'incorporant, par rapport à l'état de la technique antérieur.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

### BREVE DESCRIPTION DES DESSINS.

La **Figure 1** est un schéma de principe d'un circuit d'excitation d'un alternateur de véhicule automobile connu de l'état de la technique.
La **Figure 2** est un schéma de principe général d'un circuit d'excitation d'un alternateur de véhicule automobile selon l'invention.
La **Figure 3a** sont des diagrammes de temps d'un courant d'excitation (trait plein) et d'un courant de rupture (trait en pointillé).
La **Figure 3b** est un diagramme de temps d'une tension de rupture aux bornes d'une diode de roue libre d'un circuit d'excitation d'un alternateur de véhicule automobile connu de l'état de la technique.
La **Figure 3c** est un diagramme de temps d'une tension drain- source du second transistor de puissance d'un circuit d'excitation d'un alternateur de véhicule automobile selon l'invention.

### DESCRIPTION DES MODES DE REALISATION PREFERES DE L'INVENTION.

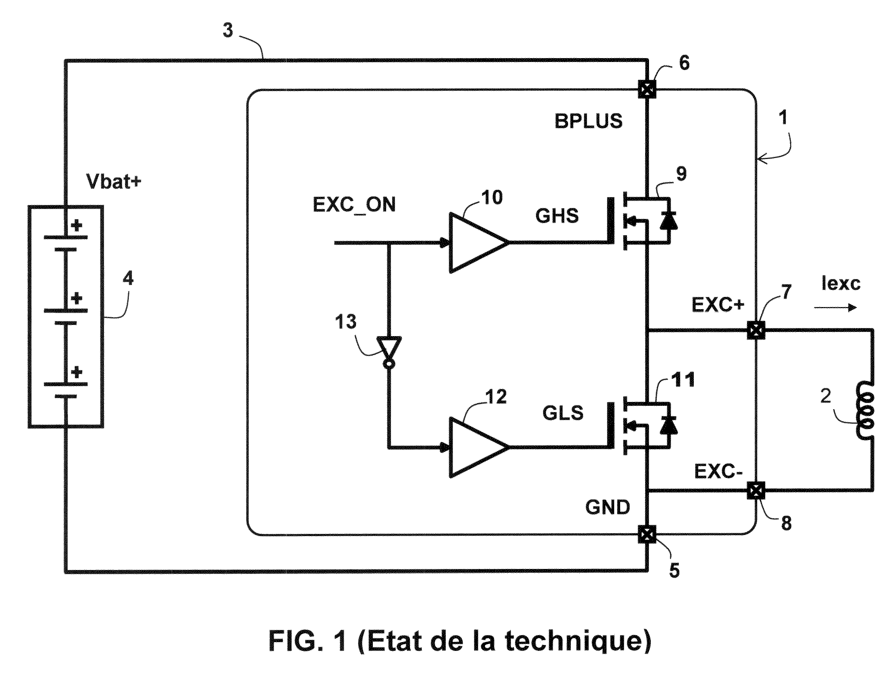

Un schéma d'un circuit d'excitation 1 du type concerné par l'invention est représenté sur la **Figure 1****.**

Il s'agit d'un circuit d'excitation 1 d'un régulateur de tension d'un alternateur à excitation pour une application dans un véhicule automobile connu de l'entité inventive.

Ce circuit d'excitation 1 permet de contrôler un courant d'excitation lexc circulant dans un enroulement d'excitation 2 de l'alternateur en fonction d'une commande EXC_ON d'une boucle de régulation d'une tension Vbat+ d'un réseau de bord 3 du véhicule alimenté par une batterie 4.

Le circuit d'excitation comporte de manière connue en soi:
- une première borne de masse 5 destinée à être reliée à une masse du réseau de bord 3;
- une première borne d'alimentation 6 destinée à être reliée à une ligne positive Vbat+ du réseau de bord 3;
- des première et seconde bornes d'excitation 7, 8 destinées à être reliées à l'enroulement d'excitation 2.

Comme le montre bien la **Figure 1****,** ce circuit d'excitation comprend:
- un premier transistor de puissance 9 de type MOS connecté entre la première borne d'alimentation 6 et la première borne d'excitation 7, apte à être commandé par la boucle de régulation au moyen d'un premier circuit de pilotage 10 d'une première tension de grille GHS.
- un second transistor de puissance 11 de type MOS connecté entre les première et seconde bornes d'excitation 7, 8 et à la première borne de masse 5 faisant fonction d'une diode de roue libre en étant commandé au moyen un second circuit de pilotage 12 d'une seconde tension de grille GLS.

Dans ce circuit d'excitation 1 connu de l'état de la technique, les première et seconde tensions de grille GHS, GLS sont pilotées en opposition de phase par la commande de la boucle de régulation EXC_ON au moyen de l'inverseur 13.

Comme cela a été rappelé en préambule, ce circuit d'excitation 1 présente de nombreux inconvénients, notamment en termes de compatibilité électromagnétique (CEM).

Dans le but de réduire les pertes en commutation, tout en satisfaisant aux contraintes CEM, l'entité inventive propose de réduire des pertes en conduction du second transistor de puissance 11 faisant fonction de diode de roue libre en combinant une diminution de sa résistance équivalente avec un contrôle autonome de la seconde tension de grille GLS, sans mode commun avec la commande de la première tension de grille GHS du premier transistor de puissance 9.

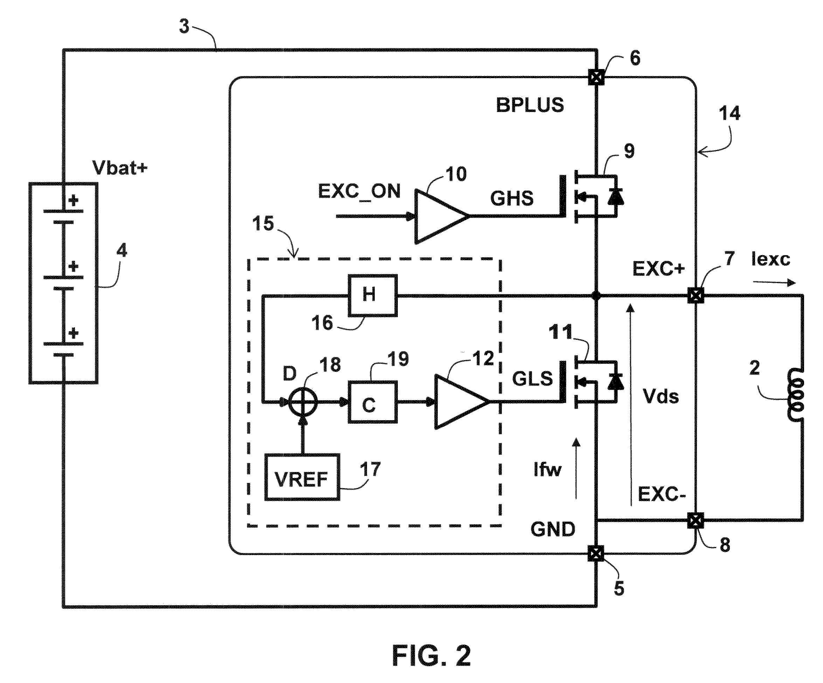

Pour ce faire, dans le circuit d'excitation 14 selon l'invention montré sur la **Figure 2****,** on contrôle le second transistor de puissance 11 afin qu'il ait un comportement de diode au moyen d'une boucle d'asservissement 15 d'une tension drain- source Vds, ce qui assure à la fois des pertes faibles et une indépendance de la tension.

L'avantage de cette solution est que le second transistor de puissance 11 faisant fonction de diode de roue libre ce comporte effectivement comme une diode. Il n'est donc pas nécessaire de modifier la stratégie de commutation par la boucle de régulation du premier transistor de puissance 9.

La boucle d'asservissement 15 de la tension drain- source Vds se décompose fonctionnellement en :
- un dispositif de retour 16 qui conditionne un signal d'entrée, c'est-à-dire la tension drain- source Vds;
- un dispositif de génération 17 d'une tension de référence VREF;
- un dispositif de calcul de l'erreur 18;
- un dispositif de correction de l'erreur 19;
- le circuit de pilotage 12 de la seconde tension de grille GLS du second transistor de puissance 11.

En phase de roue libre, le courant de rupture Ifw de l'enroulement d'excitation 2 du rotor circule en premier lieu dans la diode intrinsèque du second transistor de puissance 11. La tension aux bornes de cette diode augmente, puis la boucle d'asservissement 15 va maintenir cette tension proche de la tension de référence VREF. Lorsque le courant de rupture Ifw diminue, la boucle d'asservissement 15 va bloquer ce second transistor de puissance 11. On retrouve alors un fonctionnement dont les caractéristiques sont celles d'une diode, donc indépendant de la commande de la première tension de grille GHS du premier transistor de puissance 9, avec une tension directe (« forward ») controlée et très faible, de l'ordre de 0,1 V si la tension de référence est égale à 0,1 V, ce qui permet de réduire les pertes en conduction.

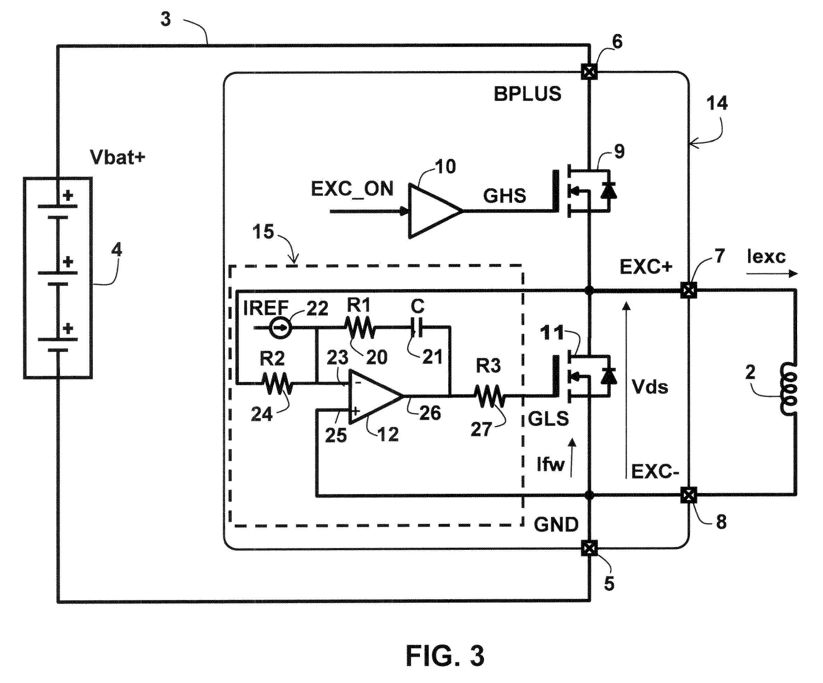

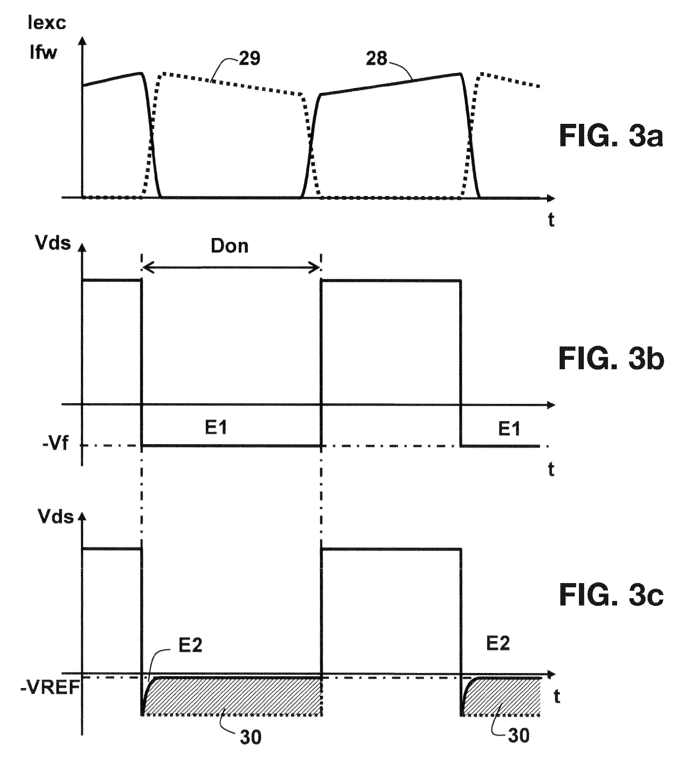

Le schéma de principe d'un mode de réalisation préféré du circuit d'excitation 14 selon l'invention est donné sur la **Figure 3****.**

L'asservissement de la tension drain-source Vds est réalisé par le second circuit de pilotage 12 qui est un amplificateur opérationnel 12 comportant une boucle de contre-réaction constituée par une première résistance 20 en série avec un condensateur 21.

La tension de référence VREF est obtenue au moyen d'un générateur de courant 22 connecté à une entrée inverseuse 23 de l'amplificateur opérationnel 12.

L'entrée inverseuse 23 de l'amplificateur opérationnel 12 est reliée par une deuxième résistance 24 à la première borne d'excitation 7, une entrée non-inverseuse 25 étant relièe à la seconde borne d'excitation 8.

Une sortie 26 de l'amplificateur opérationnel 12 pilote par l'intermédiaire d'une troisième résistance 27 la seconde tension de grille GLS du second transistor de puissance 11.

Une correction de type proportionnel intégral (PI) est ainsi utilisée, ce qui permet d'ajuster la qualité de l'asservissement. La troisième résistance 27 placée en série en sortie de l'amplificateur opérationnel 12 permet d'ajuster la dynamique du second transistor de puissance 11.

Alternativement au générateur de courant 22, une source de tension 17 de référence VREF sensiblement égale à 0,1 V peut être connectée entre l'entrée non-inverseuse 25 de l'amplificateur opérationnel 12 et la seconde borne d'excitation 8 pour ajuster une tension de décalage de la boucle de contre-réaction 20, 21.

Comme le montrent bien les diagrammes de temps des **Figures 3a, 3b et 3c****,** le gain en efficacité du circuit d'excitation 14 selon l'invention est directement lié au rapport entre une première tension de seuil Vf de la diode intrinsèque d'un circuit d'excitation connu, et une seconde tension de seuil VREF de la diode de roue libre équivalente au second transistor de puissance 11 dans le circuit d'excitation 14 selon l'invention.

La **Figure 3a** sont des diagrammes de temps du courant d'excitation lexc (trait plein 28) circulant dans le premier transistor de puissance 9 et du courant de rupture Ifw (trait en pointillé 29) circulant dans le second transistor de puissance 11 quand le premier transistor de puissance 9 est ouvert.

A ces diagrammes de temps 28, 29 des courant lexc, Ifw, correspondent les diagrammes de temps, respectivement pour un circuit d'excitation connu de l'état de la technique **(****Figure 3b****)** et pour un circuit d'excitation selon l'invention **(****Figure 3c****),** de la tension drain-source Vds du second transistor de puissance 11, qui est égale à une tension d'excitation Vexc impossée par la boucle de régulation quand le premier transistor de puissance 9 est passant, et à une tension d'asservissement imposée par la boucle d'asservissement 15 quand le premier transistor de puissance 9 est bloqué.

La **Figure 3b** montre que les pertes E1 dues au courant de rupture Ifw pendant les périodes Don de la commutation sont égales à Vf*Ifw*Don.

Dans les mêmes conditions, La **Figure 3c** montre que les pertes E2 dues au courant de rupture Ifw pendant les périodes Don de la commutation sont égales à VREF*Ifw*Don, c'est-à-dire que la réduction des pertes est sensiblement représentée par la surface hachurée 30.

Comme il va de soi, l'invention ne se limite pas aux seuls modes de réalisation préférentiels décrits ci-dessus. Notamment le type de transistors de puissance 9, 11 cité n'est pas limitatif. Les valeurs numériques indiquées ne sont pas non plus limitatives.

D'autres modes de réalisation ne sortiraient pas du cadre de la présente invention dans la mesure où ils résultent des revendications ci-après.

## Revendications

1. Circuit d'excitation (1, 14) d'un alternateur de véhicule automobile du type de ceux aptes à contrôler un courant d'excitation (Iexc) dans un enroulement d'excitation (2) dudit alternateur en fonction d'une commande (EXC_ON) d'une boucle de régulation d'une tension (Vbat+) d'un réseau de bord (3) dudit véhicule alimenté par une batterie (4) à laquelle est raccordé ledit alternateur, comportant au moins:
- une première borne de masse (5) destinée à être reliée à une masse dudit réseau de bord (3);
- une première borne d'alimentation (6) destinée à être reliée à une ligne positive (Vbat+) dudit réseau de bord (3);
- des première et seconde bornes d'excitation (7, 8) destinées à être reliées audit enroulement d'excitation (2);
et comprenant:
- un premier transistor de puissance (9) de type MOS connecté entre ladite première borne d'alimentation (6) et ladite première borne d'excitation (7), apte à être commandé par ladite boucle de régulation au moyen d'un premier circuit de pilotage (10) d'une première tension de grille (GHS) ;
- un second transistor de puissance (11) de type MOS connecté entre lesdites première et seconde bornes d'excitation (7, 8) et à ladite première borne de masse (5) faisant fonction d'une diode de roue libre en étant commandé au moyen d'un second circuit de pilotage (12) d'une seconde tension de grille (GLS);
**caractérisé en ce qu'**il comprend en outre une boucle d'asservissement (15) d'une tension drain- source (Vds) dudit second transistor de puissance (11).

2. Circuit d'excitation (14) d'un alternateur de véhicule automobile selon la revendication 1 précédente, **caractérisé en ce que** ladite boucle d'asservissement (15) comprend:
- un dispositif de retour (16) conditionnant ladite tension drain- source (Vds);
- un dispositif de génération (17) d'une tension de référence (VREF);
- un dispositif de calcul d'erreur (18);
- un dispositif de correction d'erreur (19);
- ledit second circuit de pilotage (12).

3. Circuit d'excitation (14) d'un alternateur de véhicule automobile selon la revendication 2 précédente, **caractérisé en ce que** ledit dispositif de correction (19) est de type "proportionnel intégral".

4. Circuit d'excitation (14) d'un alternateur de véhicule automobile selon la revendication 3 précédente, **caractérisé en ce que** ledit second circuit de pilotage (12) est un amplificateur opérationnel comportant une boucle de contre-réaction constituée par une première résistance (20) et un condensateur (21) en série.

5. Circuit d'excitation (14) d'un alternateur de véhicule automobile selon la revendication 4 précédente, **caractérisé en ce que** ledit dispositif de génération (17) d'une tension de référence est constitué par un générateur de courant (22) connecté à une entrée inverseuse (23) dudit amplificateur opérationnel (12).

6. Circuit d'excitation (14) d'un alternateur de véhicule automobile selon la revendication 5 précédente, **caractérisé en ce que** ledit dispositif de retour (16) est constitué par ledit amplificateur opérationnel (12), ladite entrée inverseuse (23) étant reliée par une deuxième résistance (24) à ladite première borne d'excitation (7), et une entrée non-inverseuse (25) dudit amplificateur opérationnel (12) étant reliée à ladite seconde borne d'excitation (6).

7. Circuit d'excitation (14) d'un alternateur de véhicule automobile selon la revendication 6 précédente, **caractérisé en ce qu'**une sortie (26) dudit amplificateur opérationnel (12) pilote par l'intermédiaire d'une troisième résistance (27) ladite seconde tension de grille (GLS).

8. Circuit d'excitation (14) d'un alternateur de véhicule automobile selon la revendication 4 précédente, **caractérisé en ce que** ledit dispositif de génération (17) d'une tension de référence (VREF) est connecté entre une entrée non-inverseuse (25) dudit amplificateur opérationnel (12) et ladite seconde borne d'excitation (8).

9. Régulateur de tension de véhicule, **caractérisé en ce qu'**il comprend un circuit d'excitation (14) selon l'une quelconque des revendications 1 à 8 précédentes.

10. Alternateur de véhicule automobile, **caractérisé en ce que** ledit comprend un régulateur de tension selon la revendication 9 précédente.
